# FASCICULE DE BREVET EUROPEEN

(11) **EP 3 203 656 B1**
(45) Date de publication et mention de la délivrance du brevet: **02.05.2018**
(21) Numéro de dépôt: 17152203.0
(22) Date de dépôt: 19.01.2017
(51) Int. Cl.: H04B 7/185, H04L 1/00, H04L 1/12, H04H 20/74, H03M 13/35

(54) **PROCEDE DE TRANSPORT TRANSPARENT DE PAQUETS DE DONNEES DE BOUT EN BOUT DANS UN SYSTEME DE TELECOMMUNICATIONS SPATIAL UTILISANT UN RESEAU DE SATELLITES REGENERATIFS AVEC ISLS**
VERFAHREN ZUR TRANSPARENTEN ENDE-ZU-ENDE ÜBERMITTLUNG VON DATENPAKETEN IN EINEM REGENERATIVEN SATELLITENNETZ MIT INTER-SATELLITEN VERBINDUNGEN
METHOD FOR TRANSPARENT END-TO-END DATA PACKET TRANSMISSION IN A TELECOMMUNICATIONS SYSTEM USING A REGENERATIVE SATELLITE NETWORK INCLUDING INTER-SATELLITE LINKS

(30) Priorité: 05.02.2016 FR 1600194
(43) Date de publication de la demande: 09.08.2017
(73) Titulaire: Thales, 92400 Courbevoie (FR)
(72) Inventeur: BAUDOIN, Cédric, 31100 Toulouse (FR); CHUBERRE, Nicolas, 31100 Toulouse (FR); DERVIN, Mathieu, 31100 Toulouse (FR)
(74) Mandataire: Tanguy, Yannick

(56) Documents cités:
- EP-A2- 1 796 289
- EP-A2- 1 981 202
- US-A1- 2012 127 921
- US-A1- 2014 056 335
- US-A1- 2016 037 434
- MOREL COLINE ET AL: "Link Adaptation Strategies for Next Generation Satellite Video Broadcasting: A System Approach", IEEE TRANSACTIONS ON BROADCASTING, IEEE SERVICE CENTER, PISCATAWAY, NJ, US, vol. 61, no. 4, 1 décembre 2015 (2015-12-01), pages 603-614, XP011592762, ISSN: 0018-9316, DOI: 10.1109/TBC.2015.2470355 [extrait le 2015-12-04]

## Description

La présente invention concerne un procédé de transport transparent de bout en bout de paquets de données de grande taille, ledit procédé de transport étant mis en oeuvre par un système de télécommunications spatial utilisant un réseau de satellites régénératifs, dotés de liaisons inter-satellites ISL (en anglais « Inter-Satellite Links »).

La présente invention concerne également un système de télécommunications par satellites à débit élevé, configuré pour mettre en oeuvre ledit procédé de transport transparent de bout en bout de paquets de grande taille et à débit élevé.

Le domaine technique de l'invention concerne en particulier les constellations de satellites destinées à fournir des services d'acheminement / d'amenée de flux de données (en anglais « trunking / backhauling ») à très haut débit, c'est-à-dire des services de débit supérieur à 50 Mbps par terminal, avec des liaisons inter-satellites ISL (en anglais « Inter Satellites Link ») pour définir un réseau patrimonial dans l'espace sans infrastructure sol.

De manière générale, on cherche à optimiser l'utilisation de la bande de fréquences ou ressources spectrales allouées aux services et la complexité du traitement bord des satellites, les satellites permettant de commuter des paquets de données structurés en trames à très haut débit.

Un cas particulier d'un système de télécommunications par satellites à débit élevé est celui d'un système de télécommunications, basé sur une constellation de satellites régénératifs et capables de commuter des trames DVB-S2 telles que définies dans la norme de l'ETSI (en anglais « European Télécommunications Standard Institute ») sous la référence EN 302 307 V1.1.2 (2006-06) et intitulée « Digital Video Broadcasting (DVB) ; Second génération framing structure, channel coding and modulation systems for Broadcasting, Interactive Services, News Gathering and other broadband satellite applications ». Ce système de télécommunications est décrit dans la demande de brevet, intitulée « Procédé de routage transparent de paquets de données à très haut débit dans système de télécommunications spatial utilisant un réseau de satellites régénératifs avec ISLs, et déposée conjointement à la présente demande.

A ce jour, la seule solution, connue et décrite dans la norme ETSI EN 302 307 V1.1.2 (2006-06), pour optimiser la ressource spectrale d'un transfert de trames DVB-S2 est d'utiliser une boucle de codage et modulation adaptatifs ACM (en anglais « Adaptive Coding and Modulation ») locale par liaison entre une station sol et un satellite. Un exemple d'utilisation de l'ACM pour optimiser le transfert de trames DVB-S2 est connu de la demande de brevet US2014/056335; l'article de Coline Morel et al (XP11592762) "Link Adaptation Stratégies for Next génération Satellite Video Broadcasting: A System Approach" décrit un procédé ACM basé sur le maillon faible quant au bruit d'une liaison satellite DVB-S2; la demande de brevet US2012/127921 décrit un procédé ACM utilisant des mesures séparées pour les liaisons montantes et descendantes VSAT; la demande US2016/037434 décrit l'utilisation du procédé ACM appliqué à des liaisons inter-satellite ISL; la demande EP1796289 décrit un procédé ACM bi-directionnel appliqué aux liaisons DVB-S2. L'utilisation d'un tel procédé local conduit à des couples de paramètres modulation-codage différents sur les deux liaisons constituées par une première liaison entre une première station et un premier satellite d'une part, et par une deuxième liaison entre un deuxième satellite et une deuxième station d'autre part. Cette utilisation dans le cas d'une commutation de trame DVB-S2 implique la mise en oeuvre de solutions de segmentation au niveau de la couche d'encapsulation GSE (en anglais « Generic Stream Encapsulation Protocol ») ou de concaténation au niveau des trames, conduisant pour les débits élevés considérés à des traitements complexes à réaliser.

En outre, dans le cas de liaisons à fort débit, cette optimisation fondée sur l'utilisation d'une boucle ACM par liaison station sol (départ/destination) - satellite de bord (départ/destination) peut conduire également à des pertes importantes de données dans les mémoires tampons du satellite de destination servant la station de destination si le bilan de la liaison descendante correspondante est défavorable, ainsi qu'un gain d'efficacité spectrale non utilisé dans le cas d'un accès à une seule porteuse par canal par porteuse SCPC (en anglais « Single Carrier Per Channel ») si le bilan de la liaison montante entre la station de départ et le satellite de départ est défavorable

Le problème technique est d'améliorer la performance, en termes d'optimisation de la ressource spectrale, d'un transport bout à bout de services de données à débit très élevé, acheminés d'une station de départ à une station de destination par un réseau spatial de satellites régénératifs à commutation de paquets, et de limiter la complexité bord des équipements bord des satellite permettant de réaliser la commutation des paquets de données.

Ce problème technique est à résoudre en particulier dans le cas de transport de trames utilisant le protocole DVB-S2.

A cet effet, l'invention a pour objet un procédé de transport transparent de paquets de données de bout en bout mis en oeuvre par un système de télécommunications par satellites. Le système de télécommunications comprend : une première station de départ; une deuxième station de destination ; un premier satellite de départ, connecté directement à la première station par une première liaison électromagnétique montante depuis la première station et par une première liaison électromagnétique descendante depuis le premier satellite ; un deuxième satellite de destination, connecté directement à la deuxième station par une deuxième liaison électromagnétique montante depuis la deuxième station et par une deuxième liaison électromagnétique descendante depuis le deuxième satellite. Le premier satellite de départ et le deuxième satellite de destination sont interconnectés par un réseau spatial comportant au moins une liaison inter-satellite. Le procédé de transport transparent comprend une première étape consistant en ce que la première station de départ émet un premier message de données, destiné à la deuxième station de destination et fragmenté en un unique ou plusieurs premiers paquets de données, chaque premier paquet ayant une structure générique ou trame définie par une norme prédéterminée. Le procédé de transport transparent comprend en outre les étapes consistant en ce que :
.- dans une deuxième étape, le premier satellite de départ estime un premier rapport du niveau signal à bruit et interférence SNIR1 de la première liaison montante à partir d'un premier paquet actuel reçu et insère une information représentative du premier rapport SNIR1 dans un premier champ aller de données, ajouté au paquet, et retransmet de manière transparente ledit paquet et l'information contenue dans le premier champ aller au deuxième satellite; puis
.- dans une troisième étape, le deuxième satellite retransmet ledit premier paquet et l'information contenue dans le premier champ à la deuxième station de destination ; puis
.- dans une quatrième étape, la deuxième station estime un deuxième rapport du niveau signal à bruit et interférence SNIR2 de la deuxième liaison descendante à partir dudit premier paquet retransmis par le deuxième satellite, puis détermine un troisième rapport du niveau signal à bruit et interférence SNIR3 d'une première liaison complète depuis la première station jusqu'à la deuxième station comme étant le minimum de l'ensemble formé par les premier et deuxième rapports SNIR1 et SNIR2, puis insère une information représentative du troisième rapport dans un premier champ retour de données, ajouté au ou déjà inclus dans un deuxième paquet d'un deuxième message destiné à la première station, et transmet ledit deuxième paquet et l'information contenue dans le premier champ retour à la première station via le deuxième satellite, le réseau spatial et le premier satellite, puis
.- dans une cinquième étape, la première station détermine un premier couple de paramètres de modulation et codage adapté en fonction du troisième rapport SNIR3 envoyé par la deuxième station et émet les paquets du premier message ou d'autres messages destinés à la deuxième station suivant le premier couple de paramètres.

Suivant des modes particuliers de réalisation, le procédé de transport comprend l'une ou plusieurs des caractéristiques suivantes :
.- les estimations des premier, deuxième et troisième rapports du niveau signal à bruit et interférence SNIR1, SNIR2, SNIR3 sont mises en oeuvre périodiquement suivant une période prédéterminée exprimés en temps ou en nombre de paquets ;
.- au cours de la quatrième étape, la deuxième station insère également dans le premier champ retour de données une information représentative du deuxième rapport SNIR2, et le procédé de transport comprend en outre une sixième étape, interposée entre la quatrième étape et la cinquième étape, dans laquelle le deuxième satellite reçoit et extrait les deuxième et troisième rapports SNIR2, SNIR3, puis adapte la modulation actuelle de la deuxième liaison descendante en fonction de la valeur la plus grande des deuxième et troisième rapports SNIR2, SNIR3 tout en laissant inchangé le codage actuel ;
.- le procédé de transport comprend en outre les étapes consistante en ce que : dans une septième étape, consécutive à la quatrième étape, le deuxième satellite de destination estime un quatrième rapport du niveau signal à bruit et interférence SNIR4 de la deuxième liaison montante à partir d'un deuxième paquet actuel reçu et insère une information, représentative du quatrième rapport SNIR4 dans un deuxième champ aller de données, ajouté au deuxième paquet, et retransmet de manière transparente ledit deuxième paquet et l'information contenue dans le deuxième champ aller au premier satellite; puis dans une huitième étape, le premier satellite retransmet ledit deuxième paquet et l'information contenue dans le deuxième champ aller à la première station; puis dans une neuvième étape, la première station estime un cinquième rapport du niveau signal à bruit et interférence SNIR5 de la première liaison descendante à partir dudit deuxième paquet retransmis par le premier satellite, puis détermine un sixième rapport du niveau signal à bruit et interférence SNIR6 d'une deuxième liaison complète depuis la deuxième station jusqu'à la première station comme étant le minimum de l'ensemble formé des quatrième et cinquième rapports SNIR4 et SNIR5, puis insère une information, représentative du sixième rapport SNIR6, dans un deuxième champ retour de données, ajouté dans un premier paquet du premier message ou d'un autre message destiné à la deuxième station, et transmet ledit premier paquet et l'information contenue dans le deuxième champ retour à la deuxième station via le premier satellite, le réseau spatial et le deuxième satellite ; puis dans une dixième étape, la deuxième station détermine un deuxième couple de paramètres de modulation et codage adapté en fonction du sixième rapport SNIR6 envoyé par la première station et émet les paquets du deuxième message ou d'autres messages destinés à la première station ;

.- les estimations des quatrième, cinquième et sixième rapports du niveau signal à bruit et interférence SNIR4, SNIR5, SNIR6 sont mises en oeuvre périodiquement suivant une période prédéterminée, exprimée en temps ou en nombre de paquet ;
.- au cours de la neuvième étape, la première station insère également dans le deuxième champ retour de données une information représentative du cinquième rapport SNIR5 ; et le procédé de transport comprend en outre une onzième étape, interposée entre la neuvième étape et la dixième étape, dans laquelle, le premier satellite reçoit et extrait les cinquième et sixième rapports SNIR5, SNIR6, puis adapte la modulation actuelle de la première liaison descendante en fonction de la valeur la plus grande des cinquième et sixième rapports SNIR5, SNIR6 tout en laissant inchangé le codage actuel ;
.- les étapes de signalisation, consistant à insérer et extraire dans un premier champ et un deuxième champs les informations représentatives des rapports SNIR1, SNIR2, SNIR3, SNIR4, SNIR5, SNIR6 ajoutées aux paquets, sont remplacées par des étapes d'acheminement des mesures des SNIR1, SNIR2, SNIR3, SNIR4, SNIR5, SNIR6 et de réacheminement desdites mesures à la station pertinente parmi la première station et la deuxième station ou au satellite pertinent pris parmi le satellite de départ et le satellite de destination, les étapes d'acheminement et de réacheminement étant mises en oeuvre par une station centrale de coordination du système de télécommunications ;
.- le ou les paquets de données du premier paquet et/ou du deuxième paquet de données ont la structure d'une trame de bande de base BBFRAME codée ou non codée telle que définie par le protocole DVB-S2 ;
.- les paquets de données commutés à bord des satellites sont des paquets de données ayant la structure d'une trame de bande de base BBFRAME codée selon le protocole DVB-S2 et conservant la structure du codage de bout en bout.

L'invention a également pour objet un système de télécommunications par satellites pour transporter de manière transparente des données à débit élevé de bout en bout et comprenant : une première station de départ; et une deuxième station de destination ; et un premier satellite de départ, connecté directement à la première station par une première liaison électromagnétique montante depuis la première station et par une première liaison électromagnétique descendante depuis le premier satellite ; et un deuxième satellite de destination, connecté directement à la deuxième station par une deuxième liaison électromagnétique montante depuis la deuxième station et par une deuxième liaison électromagnétique descendante depuis le deuxième satellite; le premier satellite de départ et le deuxième satellite de destination étant interconnectés par un réseau spatial comportant au moins une liaison inter-satellite; la première station de départ étant configurée dans une première étape pour émettre un premier message de données, destiné à la deuxième station de destination et fragmenté en un unique ou plusieurs premiers paquets de données, chaque premier paquet ayant une structure générique ou trame définie par une norme prédéterminée. Le système de télécommunications est caractérisé en ce que :
.- le premier satellite de départ est configuré pour estimer dans une deuxième étape un premier rapport du niveau signal à bruit et interférence SNIR1 de la première liaison montante à partir d'un premier paquet actuel reçu et insère une information, représentative du premier rapport SNIR1 dans un premier champ aller de données, ajouté au paquet, et retransmet de manière transparente ledit paquet et l'information contenue dans le premier champ aller au deuxième satellite; et
.- le deuxième satellite de destination est configuré pour retransmettre dans une troisième étape ledit premier paquet et l'information contenue dans le premier champ à la deuxième station de destination ; et
.- la deuxième station est configurée pour estimer dans une quatrième étape un deuxième rapport du niveau signal à bruit et interférence SNIR2 de la deuxième liaison descendante à partir dudit premier paquet retransmis par le deuxième satellite, puis déterminer un troisième rapport du niveau signal à bruit et interférence SNIR3 d'une première liaison complète depuis la première station jusqu'à la deuxième station comme étant le minimum de l'ensemble formé par les premier et deuxième rapports SNIR1 et SNIR2, puis insère une information, représentative du troisième rapport SNIR3 dans un premier champ retour de données, ajouté au ou déjà inclus dans un deuxième paquet d'un deuxième message destiné à la première station, et transmettre ledit deuxième paquet et l'information contenue dans le premier champ retour à la première station via le deuxième satellite, le réseau spatial et le premier satellite; et
.- la première station est configurée pour déterminer dans une cinquième étape un premier couple de paramètres de modulation et codage adapté en fonction du troisième rapport SNIR3 envoyé par la deuxième station et émettre les paquets du premier message ou d'autres messages destinés à la deuxième station suivant le premier couple de paramètres.

Suivant des modes particuliers de réalisation, le système de télécommunications par satellites comprend l'une ou plusieurs des caractéristiques suivantes :
.- le deuxième satellite de destination est configuré pour estimer dans une septième étape, consécutive à la quatrième étape, un quatrième rapport du niveau signal à bruit et interférence SNIR4 de la deuxième liaison montante à partir d'un deuxième paquet actuel reçu et insère une information représentative du quatrième rapport SNIR4 dans un deuxième champ aller de données, ajouté au deuxième paquet, et retransmettre de manière transparente ledit deuxième paquet et l'information contenu dans le deuxième champ aller au premier satellite; et le premier satellite est configuré pour retransmettre dans une huitième étape ledit deuxième paquet et l'information contenue dans le deuxième champ aller à la première station; et la première station est configurée pour estimer dans une neuvième étape un cinquième rapport du niveau signal à bruit et interférence SNIR5 de la première liaison descendante à partir dudit deuxième paquet retransmis par le premier satellite, puis déterminer un sixième rapport du niveau signal à bruit et interférence SNIR6 d'une deuxième liaison complète depuis la deuxième station jusqu'à la première station comme étant le minimum de l'ensemble formé par les quatrième et cinquième rapports SNIR4 et SNIR5, puis insérer une information, représentative du sixième rapport SNIR6, dans un deuxième champ retour de données, ajouté dans un premier paquet du premier message ou d'un autre message destiné à la deuxième station, et transmettre ledit premier paquet et l'information contenue dans le deuxième champ retour à la deuxième station via le premier satellite, le réseau spatial et le deuxième satellite ; et la deuxième station est configurée pour déterminer dans une dixième étape un deuxième couple de paramètres de modulation et codage adapté en fonction du sixième rapport SNIR6 envoyé par la première station et émettre les paquets du deuxième message ou d'autres messages destinés à la première station ;
.- le système de télécommunications comprend en outre une station centrale de coordination du système de télécommunications ; et les étapes de signalisation, consistant à insérer et extraire dans un premier champ et un deuxième champs les informations représentatives des rapports SNIR1, SNIR2, SNIR3, SNIR4, SNIR5, SNIR6 ajoutées aux paquets, sont remplacées par des étapes d'acheminement des mesures des SNIR1, SNIR2, SNIR3, SNIR4, SNIR5, SNIR6 et de réacheminement desdites mesures à la station pertinente parmi la première station et la deuxième station ou au satellite pertinent pris parmi le satellite de départ et le satellite de destination, la station centrale de coordination du système de télécommunications étant configurée pour mettre en oeuvre lesdites étapes d'acheminement et de réacheminement de signalisation.

L'invention a également pour objet un produit ou programme d'ordinateur comprenant un ensemble d'instructions configurées pour mettre en oeuvre le procédé de transport transparent tel que défini ci-dessus lorsqu'elles sont chargées dans et exécutées par un calculateur un ou plusieurs calculateurs implémentés dans le système de télécommunications tel que défini ci-dessus.

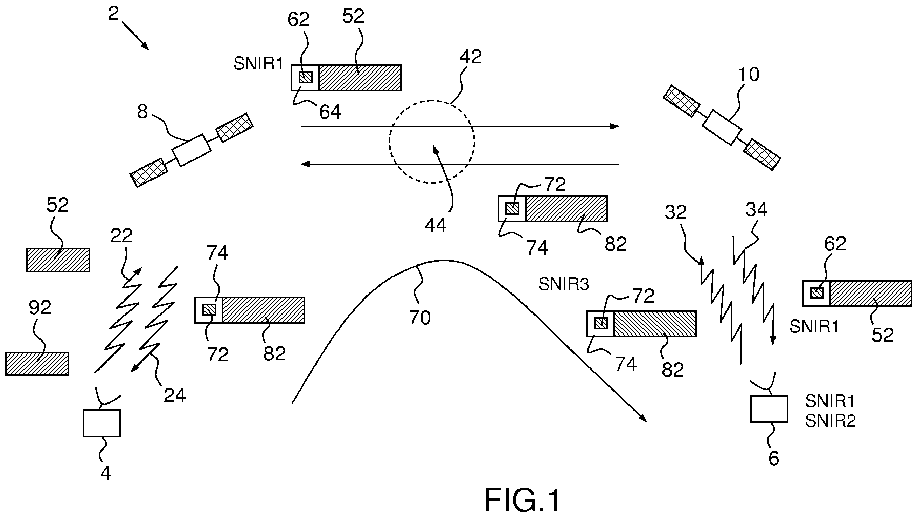

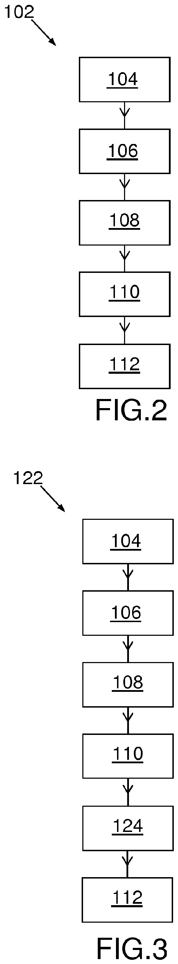

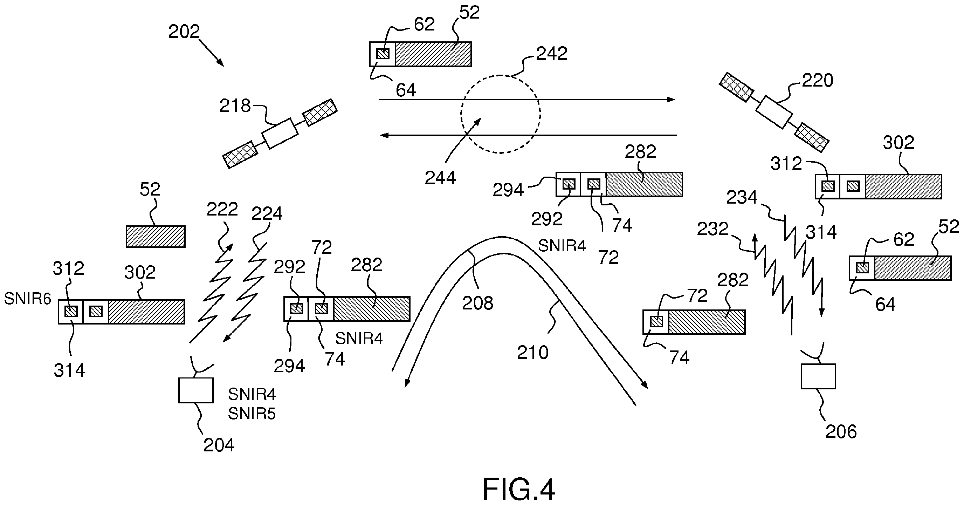

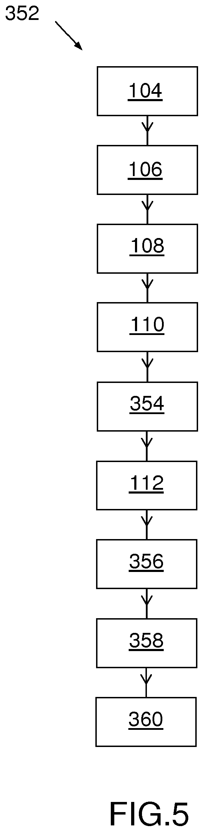

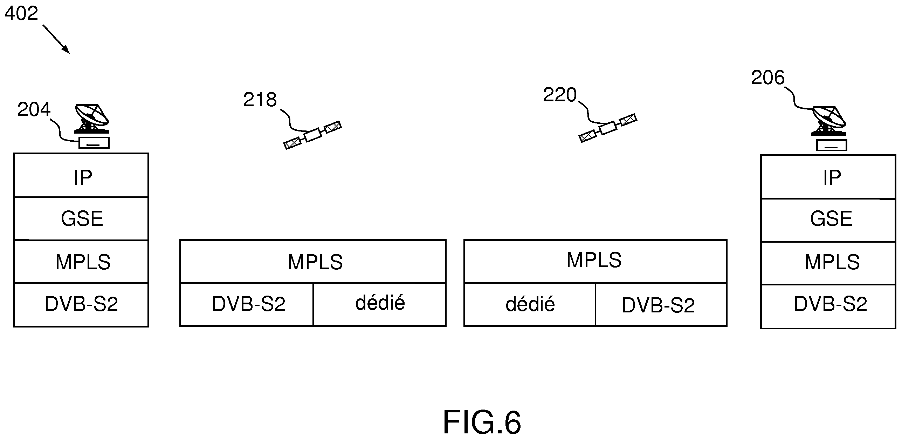

L'invention sera mieux comprise à la lecture de la description de plusieurs formes de réalisation qui va suivre, donnée uniquement à titre d'exemple et faite en se référant aux dessins sur lesquels :
.- la Figure 1 est une vue d'un système de télécommunications par satellites, configuré pour mettre en oeuvre un procédé de transport transparent de bout en bout selon l'invention de paquets de données suivant une première liaison complète depuis une première station de départ vers une deuxième station destination ;
.- la Figure 2 est un ordinogramme d'un premier mode de réalisation d'un procédé de transport transparent de bout en bout selon l'invention dans lequel des paquets de données à haut débit sont acheminés suivant une première liaison complète depuis une première station de départ vers une deuxième station de destination, le procédé de transport transparent de bout en bout étant mis en oeuvre par le système de télécommunications par satellites de la Figure 1 ;
.- la Figure 3 est un ordinogramme d'une variante du procédé de la Figure 2 dans laquelle une boucle locale d'adaptation de la modulation sur la liaison descendante du deuxième satellite de destination a été ajoutée ;
.- la Figure 4 est une vue d'un système de télécommunications par satellites selon l'invention, dérivé de celui de la Figure 1, et configuré pour mettre en oeuvre un procédé de transport bidirectionnel transparent de bout en bout de paquets de données de trafic suivant une première liaison complète orientée dans un premier sens depuis une première station vers une deuxième station, et de paquets de données de trafic suivant une deuxième liaison complète orientée dans un deuxième sens, inverse du premier sens, depuis la deuxième station vers la première station ;
.- la Figure 5 est un ordinogramme d'un deuxième mode de réalisation d'un procédé de transport bidirectionnel transparent de bout en bout selon l'invention dans lequel des paquets de données de trafic à haut débit sont acheminés suivant une première liaison complète orientée dans un premier sens depuis une première station vers une deuxième station, et des paquets de données de trafic à haut débit sont acheminés suivant une deuxième liaison complète orientée dans un deuxième sens, inverse du premier sens, depuis la deuxième station vers la première station ;
.- la Figure 6 est une pile de protocole selon une représentation OSI (en anglais « Open Systems Interconnexion ») d'un procédé de transfert de paquets de données IP à haut débit depuis une première station à une deuxième station et/ou depuis la deuxième station vers la première station, dans lequel les paquets commutés à bord des satellites du réseau spatial sont des paquets de grande taille définis selon le protocole DVB-S2 et dans lequel le procédé de transport transparent bidirectionnel de bout en bout est mis en oeuvre.

De manière générale, l'invention est fondée sur le concept de mise en oeuvre d'une boucle de contrôle adaptative de codage et modulation ACM (en anglais « Adaptive Coding and Modulation ») de bout en bout pour adapter la modulation et le codage, utilisés par les terminaux ou stations haut débit et les satellites d'un système de télécommunications spatial qui utilise des satellites régénératifs dotés d'ISLs.

Par la suite, le terme « station » désignera de manière générale un terminal du système satellite fixe ou mobile au sol, ou embarqué à bord d'un aéronef ou d'un ballon stratosphérique.

Toutefois, une station située au sol sera ici considérée de préférence en raison d'un intérêt plus grand apporté par l'invention en regard d'une dynamique des changements des conditions de propagation du rayonnement électromagnétique plus grande sur les liaisons radioélectriques connectant les stations de départ et de destination et aux satellites d'accès à la constellation de satellites.

Suivant la Figure 1, un système de télécommunications 2 par satellites pour transporter de manière transparente des données à débit élevé de bout en bout, comprend une première station 4 de départ, une deuxième station 6 de destination, un premier satellite 8 de départ et un deuxième satellite 10 de destination.

Le premier satellite 8 de départ est connecté directement à la première station 4 par une première liaison radioélectrique montante 22 depuis la première station de départ 4 et par une première liaison radioélectrique descendante 24 depuis le premier satellite 8 de départ.

Le deuxième satellite 26 de destination est connecté directement à la deuxième station 6 de destination par une deuxième liaison radioélectrique montante 32 depuis la deuxième station 6 de destination et par une deuxième liaison radioélectrique descendante 34 depuis le deuxième satellite 10 de destination.

Le premier satellite de départ 8 et le deuxième satellite de destination 10 sont interconnectés par un réseau spatial 42, représenté par un anneau en trait pointillés sur la Figure 1, comportant au moins une liaison inter-satellite 44. De manière générale, le réseau spatial 42 peut comporter d'autres satellites servant de relais et des liaisons inter-satellites reliant les satellites entre eux. Les satellites du réseau spatial, le premier satellite de départ et le deuxième satellite de destination inclus, peuvent appartenir à une même constellation parmi notamment les constellations évoluant sur des orbites basses (constellation de type LEO (en anglais Low Earth Orbit)) et les constellations évoluant sur des orbites d'altitudes moyennes (constellation MEO (en anglais Medium Earth Orbit), ou appartenir à des constellations hybrides avec éventuellement un ou plusieurs satellites géostationnaires. De manière préférée, les satellites du réseau spatial, partie intégrante du système de télécommunications, appartiennent à une constellation de type LEO.

La première station 4 de départ est configurée pour émettre dans une première étape un premier message de données, destiné à la deuxième station 6 de destination et fragmenté en un unique ou plusieurs premier paquets de données, chaque premier paquet ayant une structure générique ou trame définie par une norme prédéterminée. Ici sur la Figure 1 un premier paquet actuel 52, émis par la première station 4 de départ, ainsi qu'un premier paquet 54 du premier message émis postérieurement au premier paquet actuel 52 et donné à titre d'exemple, sont représentés.

Le premier satellite de départ 8 est configuré pour estimer, dans une deuxième étape, un premier rapport du niveau signal à bruit et interférence SNIR1 de la première liaison montante 22 à partir d'un premier paquet actuel reçu 52, et insère une information 62 représentative du premier rapport SNIR1 dans un premier champ aller de données 64, ajouté au premier paquet 52, et retransmet de manière transparente ledit paquet 52 et l'information 62 contenu dans le premier champ de données 64 au deuxième satellite de destination 10 via le réseau spatial 42.

Le deuxième satellite 10 de destination est configuré pour retransmettre, dans une troisième étape, ledit premier paquet 52 et l'information 62, contenue dans le premier champ aller de données 64, à la deuxième station 6 de destination.

La deuxième station 8 de destination est configurée pour estimer, dans une quatrième étape, un deuxième rapport du niveau signal à bruit et interférence SNIR2 de la deuxième liaison descendante 34 à partir dudit premier paquet 52 retransmis par le deuxième satellite de destination 10, puis déterminer un troisième rapport du niveau signal à bruit et interférence SNIR3 d'une première liaison complète 70 depuis la première station de départ 4 jusqu'à la deuxième station 6 de destination comme étant le minimum de l'ensemble formé par les premier et deuxième rapports SNIR1 et SNIR2.

La deuxième station 8 de destination est configurée pour insérer ensuite dans la même quatrième étape une information retour 72 représentative du troisième rapport SNIR3 dans un premier champ retour 74 de données, ajouté à un deuxième paquet 82 d'un deuxième message destiné à la première station 4 de départ, et transmettre ledit deuxième paquet 82 et l'information retour 72 contenue dans le premier champ retour de données 74 à la première station 4 de départ via le deuxième satellite de destination 10, le réseau spatial 42 et le premier satellite 8 de départ.

La première station 4 de départ est configurée pour déterminer dans une cinquième étape un premier couple de paramètres de modulation et codage, adaptés en fonction de l'information retour 72 représentative du troisième rapport SNIR3 envoyée par la deuxième station 6 de destination, et émettre postérieurement au premier paquets actuel 52 un ou des premiers paquets 54 du premier message.

En variante, une ou plusieurs des liaisons radioélectriques prises parmi la première liaison radioélectrique montante 22, la première liaison radioélectrique descendante 24, la deuxième liaison radioélectrique montante 32, la deuxième liaison radioélectrique descendante 34 sont des liaisons optiques.

De manière générale, la première liaison radioélectrique montante, la première liaison radioélectrique descendante, la deuxième liaison radioélectrique montante, la deuxième liaison radioélectrique descendante sont des liaisons électromagnétiques.

Suivant la Figure 2, un procédé de transport transparent 102 de paquets de données de bout en bout est mis en oeuvre par le système de télécommunications par satellites 2 de la Figure 1 et comprend des première, deuxième, troisième, quatrième et cinquième étapes 104, 106, 108,110 et 112.

Dans la première étape 104, la première station 4 de départ émet un premier paquet actuel 52 d'un premier message de données, destiné à la deuxième station 6 de destination, le premier message ayant été fragmenté en plusieurs premiers paquets de données, chaque premier paquet ayant une structure générique ou trame définie par une norme prédéterminée. Par exemple, chaque premier paquet est un paquet BBFRAME, codé ou non codé, défini selon le protocole lm DVB-S2.

Ensuite dans la deuxième étape 106, le premier satellite 8 de départ mesure et estime à l'aide d'un récepteur et/ou d'un démodulateur, un premier rapport du niveau signal à bruit et interférence SNIR1 de la première liaison montante 22 à partir du premier paquet actuel reçu et insère une information aller représentative du premier rapport SNIR1 dans un premier champ aller 64 de données, ajouté au premier paquet actuel 52, et retransmet de manière transparente ledit premier paquet actuel 52 et l'information aller 62, contenue dans le premier champ aller 64, au deuxième satellite 8 de destination via le réseau satellite 42.

Puis, dans une troisième étape 108, le deuxième satellite 10 de destination retransmet ledit premier paquet actuel 52 et l'information aller 62, contenue dans le premier champ aller 64 à la deuxième station 6 de destination.

Ensuite, dans la quatrième étape 110, la deuxième station de destination 6 mesure et estime, à l'aide d'un récepteur et/ou d'un démodulateur, un deuxième rapport du niveau signal à bruit et interférence SNIR2 de la deuxième liaison descendante 34 à partir dudit premier paquet actuel 52 retransmis par le deuxième satellite 10, puis détermine un troisième rapport du niveau signal à bruit et interférence SNIR3 d'une première liaison complète 70 depuis la première station 4 de départ jusqu'à la deuxième station 6 de destination, comme étant le minimum de l'ensemble formé par les premier et deuxième rapports SNIR1 et SNIR2.

Puis, au cours de la quatrième étape 110, la deuxième station 6 de destination insère une information retour 72, représentative du troisième rapport SNIR3, dans le premier champ retour 74 de données, ajouté à un deuxième paquet de données 82 d'un deuxième message, destiné à la première station de départ 4, et transmet ledit deuxième paquet 82 et l'information retour 72, contenue dans le premier champ retour 74 de données à la première station 4 de départ via le deuxième satellite 10 de destination, le réseau spatial 42 et le premier satellite 8 de départ.

Ensuite, dans la cinquième étape 112, la première station 4 de départ détermine un premier couple de paramètres de modulation et codage adapté ACM en fonction de l'information retour 72, représentative du troisième rapport SNIR3 envoyé par la deuxième station de destination 6, et émet postérieurement au premier paquet actuel 52, un ou plusieurs premiers paquets postérieurs 92.

Périodiquement, des premiers paquets postérieurs 92 sont considérés comme des premiers paquets actuels et leur sont appliqués à nouveau les première, deuxième, troisième, quatrième et cinquième étapes 104, 106, 108,110, 112 de manière correspondante.

Les première, deuxième, troisième, quatrième et cinquième étapes 104, 106, 108, 110, 112 forment ainsi une boucle d'adaptation du codage et de la modulation de la liaison 70 de bout en bout qui rend transparent le transport des paquets de données de grande taille dans le système de télécommunications 2 avec une efficacité spectrale améliorée.

De manière générale, les estimations des premier, deuxième et troisième rapports du niveau signal à bruit et interférence SNIR1, SNIR2, SNIR3 sont mises en oeuvre périodiquement suivant une période prédéterminée exprimés en temps ou en nombre n de paquets.

De manière préférée, le nombre n de paquets fixant la périodicité des estimations des trois rapports du niveau signal à bruit et interférence SNIR1, SNIR2, SNIR3 est supérieur ou égal à deux, afin de limiter les traitements bord à réaliser par les satellites

Le transport des informations représentatives des rapports SNIR1 et, SNIR3 est effectué par un premier champ de données ayant un nombre de bits compris entre 4 et 16 bits, de préférence égale à 8 bits.

Le premier champ est ajouté et disposé en tête, ou en queue, ou au sein du paquet de données de grande taille lorsque le paquet est codé suivant une norme prédéterminée, ou est réservé en tête au sein de la charge utile du paquet, lorsque le paquet est non codé et défini suivant une norme prédéterminée.

La boucle de contrôle adaptative de codage et modulation ACM (en anglais « Adaptive Coding and Modulation ») de bout en bout ainsi réalisée permet d'adapter la modulation et le codage utilisés par les terminaux ou stations haut débit et les satellites, lors d'un transport de bout en bout de paquets de grande taille et à débit élevé depuis la station de départ jusqu'à la station de destination. Cette boucle permet de limiter la taille des mémoires tampons (en anglais « buffer ») sur la liaison descendante depuis le satellite de destination vers la station de destination.

Par ailleurs, le codage étant peu, voire pas du tout modifié sur l'ensemble du chemin de communication, un acheminement transparent des trames BBFRAME est possible sans traitement bord supplémentaire, avec pour effet une optimisation de la ressource spectrale.

Suivant la Figure 3 et une variante du procédé de transport transparent de paquets de données de bout en bout 102 de la Figure 2, un procédé de transport transparent de paquets de données de bout en bout 122 selon l'invention comprend les mêmes étapes 104, 106, 108, 110, 112 que le procédé de transport 102 de la Figure 2, et comporte en outre une sixième étape 124, interposée entre la quatrième étape 110 et la cinquième étape 112.

Ici, il est supposé qu'au cours de la quatrième étape, la deuxième station insère également dans le premier champ retour de données une information représentative du deuxième rapport SNIR2.

Au cours de la sixième étape 124, le deuxième satellite 10 de destination reçoit et extrait les deuxième et troisième rapports SNIR2, SNIR3, puis adapte la modulation actuelle de la deuxième liaison descendante, mise en oeuvre par le deuxième satellite 10 de destination, en fonction de la valeur la plus grande de l'ensemble formé par les deuxième et troisième rapports SNIR2, SNIR3, tout en laissant inchangé le codage actuel.

Suivant la Figure 4 et un deuxième mode de réalisation, un système de télécommunications par satellites 202 selon l'invention, dérivé du système de télécommunications par satellites 2 de la Figure 1, est configuré pour mettre en oeuvre un procédé de transport transparent de bout en bout et bidirectionnel de paquets de données suivant une première liaison complète 208 orientée selon un premier sens depuis une première station 204 vers une deuxième station 206, et de paquets de données suivant une deuxième liaison complète 210 orientée selon un deuxième sens, inverse du premier sens, depuis la deuxième station 206 vers la première station 204.

Le système de télécommunications 202 par satellites pour transporter de manière transparente et bidirectionnelle des données de trafic à débit élevé de bout en bout, comprend à l'instar du système de télécommunications 2, la première station 204, considéré comme une première station de départ vis-à-vis de la première liaison complète 208, la deuxième station de destination 206, considéré comme une deuxième station de destination vis-à-vis de la première liaison complète 208, un premier satellite 218 et un deuxième satellite 220, considérés comme un premier satellite de départ et un deuxième satellite de destination vis-à-vis de la première liaison 208. Ici, la première liaison 208 correspond à la première liaison de bout en bout 70 du système de télécommunications 2 de la Figure 1.

Par la suite, la première station 204 et la deuxième station 206 seront désignées conventionnellement et respectivement par « première station de départ » et « deuxième station de destination », même si la première station 204 et la deuxième station 206 constituent respectivement en réalité une station de destination et une station de départ vis-à-vis de la deuxième liaison de bout en bout 210

Par la suite, le premier satellite 218 et le deuxième satellite 220 seront désignés conventionnellement et respectivement par « premier satellite de départ » et « deuxième satellite de destination », même si le premier satellite 218 et le deuxième satellite 220 constituent respectivement en réalité un satellite de destination et un satellite de départ vis-à-vis de la deuxième liaison de bout en bout 210.

Le premier satellite 218 de départ est connecté directement à la première station 204 par une première liaison radioélectrique montante 222 depuis la première station 204 de départ et par une première liaison radioélectrique descendante 224 depuis le premier satellite de départ 218.

Le deuxième satellite 220 de destination est connecté directement à la deuxième station 206 de destination par une deuxième liaison radioélectrique montante 232 depuis la deuxième station 206 de destination et par une deuxième liaison radioélectrique descendante 234 depuis le deuxième satellite 220 de destination.

Le premier satellite 218 de départ et le deuxième satellite 220 de destination sont interconnectés par un réseau spatial 242, représenté par un anneau en trait pointillés sur la Figure 4, comportant au moins une liaison inter-satellite 244.

Il est à remarquer qu'en dépit de la représentation du réseau spatial 242 par un anneau, le réseau spatial 242 peut ne pas comporter de boucle et être un réseau ouvert.

La première station 204 de départ, la deuxième station 206 de destination, le premier satellite 218 de départ, le deuxième satellite 220 de destination, le réseau spatial 242, sont configurés pour, à l'instar des première station 4 de départ, deuxième station 6 de destination, premier satellite 8 de départ, deuxième satellite 10 de destination, réseau spatial 42 de la Figure 1, mettre en oeuvre le procédé de transport transparent 102 des paquets haut débit de la Figure 2 et sa variante 122 de la Figure 3, dans lesquels des premiers paquets 52, à haut débit et de grande taille, d'un premier message sont acheminés depuis la première station 4 de départ vers la deuxième station 6 de destination.

Ici sur la Figure 4, le premier paquet, l'information représentative du premier rapport SNIR1, le premier champ aller de données, l'information représentative du troisième rapport SNIR3, le premier champ de retour de données sont respectivement désignés par les mêmes références numériques 52, 62, 64, 72, 74 des éléments correspondants de la Figure 1.

Ici sur la Figure 4, un deuxième paquet 282 de deuxième message, correspondant au deuxième paquet 82 de la Figure 1, diffère dudit deuxième paquet 82 en ce qu'il est exclusivement un deuxième paquet à haut débit et de grande taille, destiné à acheminer, de manière symétrique en terme de charge, du trafic sur la deuxième liaison de bout en bout 210 depuis la deuxième station de destination 206 vers la première station de départ 204.

Ainsi, le système de télécommunications par satellites 202 est configuré pour mettre en oeuvre les première, deuxième, troisième, quatrième, cinquième, sixième étapes 104, 106, 108, 110, 112, 114 des procédés de transport de bout en bout 102, 122 des Figures 2 et 3.

Suivant la Figure 4, la deuxième station de destination 206 est configurée pour insérer dans la quatrième étape l'information retour 72 représentative du troisième rapport SNIR3 dans le premier champ retour 74 de données, ajouté à un deuxième paquet actuel 282 du deuxième message destiné à la première station 204 de départ, et transmettre ledit deuxième paquet actuel 282 et l'information retour 72 contenue dans le premier champ retour de données 74 à la première station 204 de départ via le deuxième satellite 220 de destination, le réseau spatial 242 et le premier satellite 218 de départ.

Le deuxième satellite 220 de destination est configuré pour mesurer et estimer par un récepteur et/ou un démodulateur, dans une septième étape, consécutive à la quatrième étape 110 et antérieure à la cinquième étape 112, un quatrième rapport du niveau signal à bruit et interférence SNIR4 de la deuxième liaison montante 232 à partir du deuxième paquet actuel 282 reçu et insère une information 292, représentative du quatrième rapport SNIR4 dans un deuxième champ aller de données 294, ajouté au deuxième paquet 282, et retransmettre de manière transparente ledit deuxième paquet 282, l'information 72 contenue dans le premier champ retour 74, et l'information 292 contenue dans le deuxième champ aller 294 au premier satellite de départ 218.

Le premier satellite 218 de départ est configuré pour retransmettre dans une huitième étape ledit deuxième paquet actuel 282, le premier champ retour 74 et son contenu 72, et le deuxième champ aller 294 et son contenu 292.

La première station 204 de départ est configurée pour mesurer et estimer, dans une neuvième étape, un cinquième rapport du niveau signal à bruit et interférence SNIR5 de la première liaison descendante 224 à partir dudit deuxième paquet 282 retransmis par le premier satellite de départ 218, puis déterminer un sixième rapport du niveau signal à bruit et interférence SNIR6 de la deuxième liaison complète 210 depuis la deuxième station de destination 206 jusqu'à la première station 204 de départ, comme étant le minimum de l'ensemble formé par les quatrième et cinquième rapports SNIR4 et SNIR5, puis insérer une information 312 représentative du sixième rapport SNIR6 dans un deuxième champ de données retour 314, ajouté dans un premier paquet 302 du premier message destiné à la deuxième station 206 de destination, et transmettre ledit premier paquet 302 et l'information 312 contenue dans le deuxième champ retour 314 à la deuxième station 206 de destination via le premier satellite 218 de départ, le réseau spatial 242 et le deuxième satellite 220 de destination.

La deuxième station 206 de destination est configurée pour déterminer, dans une dixième étape, un deuxième couple de paramètres de modulation et codage, adaptés en fonction de l'information retour 312, représentative du sixième rapport SNIR6 et envoyée par la première station de départ 204, et émettre postérieurement au deuxième paquet actuel 282 un ou des deuxièmes paquets du deuxième message.

En variante, une ou plusieurs des liaisons radioélectriques prises parmi la première liaison radioélectrique montante 222, la première liaison radioélectrique descendante 224, la deuxième liaison radioélectrique montante 232, la deuxième liaison radioélectrique descendante 234 sont des liaisons optiques.

De manière générale, la première liaison radioélectrique montante, la première liaison radioélectrique descendante, la deuxième liaison radioélectrique montante, la deuxième liaison radioélectrique descendante sont des liaisons électromagnétiques.

Suivant la Figure 5 et un deuxième mode de réalisation d'un procédé de transport transparent de bout en bout, un procédé de transport transparent 352 de bout en bout de paquets de données à haut débit est mis en oeuvre par le système de télécommunications 202 de la Figure 4.

Au cours du procédé de transport transparent de bout en bout 352, des premiers paquets de données de trafic à haut débit sont acheminés suivant la première liaison complète 208 depuis la première station 204 vers la deuxième station 206, et des deuxièmes paquets de données de trafic à haut débit sont acheminés suivant la deuxième liaison complète 210 depuis la deuxième station 206 vers la première station 204.

Le procédé de transport transparent 352 de bout en bout est dérivé du procédé de transport transparent 102 de bout en bout, et comprend les mêmes première, deuxième, troisième, quatrième, cinquième étapes 104, 106, 108, 110, 112.

Le procédé de transport transparent 352 comprend en outre des septième, huitième, neuvième étapes, 354, 356, 358.

Dans la septième étape 354, consécutive à la quatrième étape 110 et antérieure à la cinquième étape 112, le deuxième satellite 220 de destination mesure et estime un quatrième rapport du niveau signal à bruit et interférence SNIR4 de la deuxième liaison montante 232 à partir d'un deuxième paquet actuel reçu 282 et insère une information 292, représentative du quatrième rapport SNIR4 dans un deuxième champ aller 294 de données, ajouté audit deuxième paquet actuel, et retransmet de manière transparente ledit deuxième paquet 282, l'information 72 contenue dans le premier champ retour 74, et l'information 292 contenue dans le deuxième champ aller 294 au premier satellite 218 de départ.

Puis dans la huitième étape 356, le premier satellite 204 de départ retransmet ledit deuxième paquet actuel 292, le premier champ retour 74 et son contenu 72, et le deuxième champ aller 294 et son contenu 292.

Ensuite dans la neuvième étape 358, la première station 204 de départ mesure et estime un cinquième rapport du niveau signal à bruit et interférence SNIR5 de la première liaison descendante 224 à partir dudit deuxième paquet 282 retransmis par le premier satellite 218 de départ, puis détermine un sixième rapport du niveau signal à bruit et interférence SNIR6 de la deuxième liaison complète 210 depuis la deuxième station 206 jusqu'à la première station 204, comme étant le minimum de l'ensemble formé par les quatrième et cinquième rapports SNIR4 et SNIR5, puis insère une information 312 représentative du sixième rapport SNIR6 dans un deuxième champ retour 314 de données, ajouté dans un premier paquet 302 du premier message destiné à la deuxième station 206, et transmet ledit premier paquet 302 et l'information 312 contenue dans le deuxième champ retour 314 à la deuxième station 206 via le premier satellite 218, le réseau spatial 242 et le deuxième satellite 220.

Puis dans la dixième étape 360, la deuxième station de destination 206 détermine un deuxième couple de paramètres de modulation et codage, adaptés en fonction de l'information retour 312, représentative du sixième rapport SNIR6 envoyée par la première station 204 de départ, et émet postérieurement au deuxième paquet actuel 282 un ou des deuxièmes paquets du deuxième message.

De manière générale, les estimations des premier, deuxième et troisième rapports du niveau signal à bruit et interférence SNIR1, SNIR2, SNIR3 sont mises en oeuvre périodiquement suivant une période prédéterminée, exprimée en temps ou en nombre n de paquets.

De manière préférée, le nombre n de paquets fixant la périodicité des estimations des six rapports du niveau signal à bruit et interférence SNIR1, SNIR2, SNIR3, SNIR4, SNIR5, SNIR6 est supérieur ou égal à deux, afin de limiter les traitements bord à réaliser par les satellites

Le transport des informations représentatives des rapports SNIR1, SNIR3, SNIR4 et SNIR6 est effectué par un premier champ et un deuxième champ de données ayant chacun un nombre de bits compris entre 4 et 16 bits, de préférence égale à 8 bits.

Les premier et deuxième champs sont ajoutés et disposés en tête, ou en queue, ou au sein du paquet de données de grande taille lorsque le paquet est codé suivant une norme prédéterminée, ou sont réservés en tête au sein de la charge utile du paquet lorsque le paquet est non codé et défini suivant une norme prédéterminée.

Les paquets codés ou non codés utilisent par exemple le protocole DVB-S2.

Les deux boucles de contrôle adaptative de codage et modulation ACM (en anglais « Adaptive Coding and Modulation ») de bout en bout ainsi réalisées permettent d'adapter la modulation et le codage utilisés par les terminaux ou stations haut débit et les satellites lors d'un transport de bout en bout de paquets de trafic de grande taille et de débit élevé, suivant la première direction complète de communication depuis la première station vers la deuxième station, et suivant la deuxième direction de communication de sens inverse depuis la deuxième station vers la première station. Ces deux boucles permettent de limiter la taille des mémoires tampons (en anglais « buffer ») sur les deux liaisons d'accès descendantes, à savoir la première liaison descendante depuis le premier satellite vers la première station et la deuxième liaison descendante depuis le deuxième satellite vers la deuxième station.

Par ailleurs, le codage étant peu, voire pas du tout modifié sur l'ensemble des deux chemins de communication lorsque des paquets BBFRAME codés ou non codés définis par le protocole DVB-S2 est utilisé, un acheminement transparent des paquets BBFRAMES est possible sans traitement bord supplémentaire, avec pour effet une optimisation de la ressource spectrale.

Suivant une variante du procédé de transport transparent de paquets de données de bout en bout 352 de la Figure 5, un procédé de transport transparent de paquets de données de bout en bout selon l'invention comprend les mêmes étapes 104, 106, 108, 110, 112, 354, 356, 358, 360 que le procédé de transport 352 de la Figure 5, et comporte en outre une onzième étape, interposée entre la neuvième étape 358 et la dixième étape 360.

Ici il est supposé qu'au cours de la neuvième étape 358, la première station insère également dans le deuxième champ retour de données une information représentative du cinquième rapport SNIR5.

Au cours de la onzième étape, le premier satellite de départ 218 reçoit et extrait les cinquième et sixième rapports SNIR5, SNIR6, puis adapte la modulation actuelle de la première liaison descendante, mise en oeuvre par le premier satellite de départ 218, en fonction de la valeur la plus grande de l'ensemble formé par les cinquième et sixième rapports SNIR5, SNIR6, tout en laissant inchangé le codage actuel.

Il est à remarquer que les divers modes de réalisation du procédé de transport transparent selon l'invention décrivent ci-dessus peuvent être mis en oeuvre également par une architecture plus centralisée du système de télécommunications dans laquelle les mesures des SNIRs sont envoyées à un centre de coordination qui les réachemine aux stations et aux satellites.

Dans ce cas, le système de télécommunications par satellites selon l'invention comprend en outre une station centrale de coordination du système de télécommunications. Le système de télécommunications est configuré pour acheminer les mesures des SNIR1, SNIR2, SNIR3, SNIR4, SNIR5, SNIR6 depuis les satellites et les stations vers la station centrale de coordination et faire réacheminer lesdites mesures par la station centrale de coordination aux stations pertinentes parmi la première station et la deuxième station et/ou aux satellites pertinents pris parmi le satellite de départ et le satellite de destination.

Un produit ou programme d'ordinateur comprend un ensemble d'instructions, configurées pour mettre en oeuvre les divers modes de réalisation du procédé de transport transparent décrites ci-dessus. Les instructions de cet ensemble sont chargées dans et exécutées par un calculateur un ou plusieurs calculateurs implémentés dans le système de télécommunications décrit dans les Figures 1 et 4.

Suivant la Figure 6, une pile 402 de protocoles d'un procédé de transfert de paquets de données IP à haut débit depuis la première station 204 à la deuxième station 206 de la Figure 4 est fournie selon une représentation OSI. Le procédé de transfert utilise ici le procédé de transport bout en bout 352 de paquets de données de grande taille et de haut débit, tel que décrit par la Figure 5.

Ici, de manière particulière et non limitative, on suppose que chaque paquet est un paquet BBFRAME avant codage, défini selon la norme DVB-S2, qui comporte au sein de sa charge utile un ou plusieurs paquets GSE définis par l'ETSI selon le protocole GSE (en anglais « Generic Stream Encapsulation Protocol »), les paquets GSE encapsulant à leur tour des paquets IP. Le procédé de transport transparent de bout en bout 352 utilise des champs de données, disponibles dans des étiquettes de routage bord, lesdites étiquettes de routage bord servant à router les paquets DVB-S2 en utilisant un protocole MPLS (en anglais « Multi-Protocol Label Switching »).

## Revendications

1. Procédé de transport transparent de paquets de données de bout en bout mis en oeuvre par un système de télécommunications (2 ; 202) par satellites,
le système de télécommunications (2 ; 202) comprenant Une première station (4 ; 204) de départ; et
Une deuxième station (6 ; 206) de destination ; et
Un premier satellite (8 ; 218) de départ, connecté directement à la première station (4 ; 204) par une première liaison électromagnétique montante (22 ; 222) depuis la première station (4 ; 204) et par une première liaison électromagnétique descendante (24 ; 224) depuis le premier satellite ; et
Un deuxième satellite (10 ; 220) de destination, connecté directement à la deuxième station (6 ; 206) par une deuxième liaison électromagnétique montante (32 ; 232) depuis la deuxième station (6 ; 206) et par une deuxième liaison électromagnétique descendante (34 ; 234) depuis le deuxième satellite (10 ; 220);
Le premier satellite (8 ; 218) de départ et le deuxième satellite de destination (10 ; 220) étant interconnectés par un réseau spatial (42 ; 242) comportant au moins une liaison inter-satellite (44 ; 244);
Le procédé de transport transparent comprenant une première étape (104) consistant en ce que :
.- la première station (4 ; 204) de départ émet un premier message de données, destiné à la deuxième station (6 ; 206) de destination et fragmenté en un unique ou plusieurs premiers paquets de données (52, 92 ; 302), chaque premier paquet (52, 92 ; 302) ayant une structure générique ou trame définie par une norme prédéterminée,
le procédé de transport transparent comprenant en outre les étapes consistant en ce que
Dans une deuxième étape (106), le premier satellite (8 ; 218) de départ estime un premier rapport du niveau signal à bruit et interférence SNIR1 de la première liaison montante (22 ; 222) à partir d'un premier paquet actuel (52) reçu et insère une information (62) représentative du premier rapport SNIR1 dans un premier champ aller de données (64), ajouté au paquet (52), et retransmet de manière transparente ledit paquet (52) et l'information (62) contenue dans le premier champ aller (64) au deuxième satellite (10 ; 220); puis
Dans une troisième étape (108), le deuxième satellite (10 ; 220) retransmet ledit premier paquet (52) et l'information (62) contenue dans le premier champ (64) à la deuxième station (6 ; 206) de destination ; puis
Dans une quatrième étape (110), la deuxième station (6 ; 206) estime un deuxième rapport du niveau signal à bruit et interférence SNIR2 de la deuxième liaison descendante (34 ; 234) à partir dudit premier paquet (52) retransmis par le deuxième satellite (10 ; 220), puis détermine un troisième rapport du niveau signal à bruit et interférence SNIR3 d'une première liaison complète (70 ; 208) depuis la première station (4 ; 204) jusqu'à la deuxième station (6 ; 206) comme étant le minimum de l'ensemble formé par les premier et deuxième rapports SNIR1 et SNIR2, puis insère une information (72) représentative du troisième rapport dans un premier champ retour (74) de données, ajouté au ou déjà inclus dans un deuxième paquet (82 ; 282) d'un deuxième message destiné à la première station (4 ; 204), et transmet ledit deuxième paquet (82 ; 282) et l'information (72) contenue dans le premier champ retour (74) à la première station (4 ; 204) via le deuxième satellite (10 ; 220), le réseau spatial (42 ; 242) et le premier satellite (8, 218), puis
Dans une cinquième étape (112), la première station (4 ; 204) détermine un premier couple de paramètres de modulation et codage adapté en fonction du troisième rapport SNIR3 envoyé par la deuxième station (6 ; 206) et émet les paquets (92 ; 302) du premier message ou d'autres messages destinés à la deuxième station (6 ; 206) suivant le premier couple de paramètres.

2. Procédé de transport transparent selon la revendication 1, les estimations des premier, deuxième et troisième rapports du niveau signal à bruit et interférence SNIR1, SNIR2, SNIR3 sont mises en oeuvre périodiquement suivant une période prédéterminée exprimés en temps ou en nombre de paquets.

3. Procédé de transport transparent selon l'une quelconque des revendications 1 et 2, dans lequel, au cours de la quatrième étape, la deuxième station insère également dans le premier champ retour de données une information représentative du deuxième rapport SNIR2 ;
le procédé de transport comprenant en outre une sixième étape (124), interposée entre la quatrième étape (110) et la cinquième étape (112), dans laquelle le deuxième satellite (10 ; 220) reçoit et extrait les deuxième et troisième rapports SNIR2, SNIR3, puis adapte la modulation actuelle de la deuxième liaison descendante (34) en fonction de la valeur la plus grande des deuxième et troisième rapports SNIR2, SNIR3 tout en laissant inchangé le codage actuel.

4. Procédé de transport transparent selon l'une quelconque des revendications 1 à 3, comprenant en outre les étapes consistante en ce que
Dans une septième étape (354), consécutive à la quatrième étape (110), le deuxième satellite (220) de destination estime un quatrième rapport du niveau signal à bruit et interférence SNIR4 de la deuxième liaison montante (232) à partir d'un deuxième paquet actuel (282) reçu et insère une information (292), représentative du quatrième rapport SNIR4 dans un deuxième champ aller (294) de données, ajouté au deuxième paquet (282), et retransmet de manière transparente ledit deuxième paquet (282) et l'information (292) contenue dans le deuxième champ aller (294) au premier satellite (218); puis
Dans une huitième étape (356), le premier satellite retransmet ledit deuxième paquet (282) et l'information (292) contenue dans le deuxième champ aller (294) à la première station (204) ; puis
Dans une neuvième étape (358), la première station (204) estime un cinquième rapport du niveau signal à bruit et interférence SNIR5 de la première liaison descendante (224) à partir dudit deuxième paquet (282) retransmis par le premier satellite (218), puis détermine un sixième rapport du niveau signal à bruit et interférence SNIR6 d'une deuxième liaison complète (210) depuis la deuxième station (206) jusqu'à la première station (204) comme étant le minimum de l'ensemble formé des quatrième et cinquième rapports SNIR4 et SNIR5, puis insère une information (312), représentative du sixième rapport SNIR6, dans un deuxième champ retour (314) de données, ajouté dans un premier paquet (302) du premier message ou d'un autre message destiné à la deuxième station (206), et transmet ledit premier paquet (302) et l'information (312) contenue dans le deuxième champ retour (314) à la deuxième station (206) via le premier satellite (218), le réseau spatial (242) et le deuxième satellite (220), puis
Dans une dixième étape (360), la deuxième station (206) détermine un deuxième couple de paramètres de modulation et codage adapté en fonction du sixième rapport SNIR6 envoyé par la première station (204) et émet les paquets du deuxième message ou d'autres messages destinés à la première station (204).

5. Procédé de transport transparent selon la revendication 4, les estimations des quatrième, cinquième et sixième rapports du niveau signal à bruit et interférence SNIR4, SNIR5, SNIR6 sont mises en oeuvre périodiquement suivant une période prédéterminée, exprimée en temps ou en nombre de paquets.

6. Procédé de transport transparent selon l'une quelconque des revendications 4 et 5, dans lequel, au cours de la neuvième étape, la première station insère également dans le deuxième champ retour de données une information représentative du cinquième rapport SNIR5 ;
le procédé de transport comprenant en outre une onzième étape, interposée entre la neuvième étape (358) et la dixième étape (360), dans laquelle, le premier satellite (218) reçoit et extrait les cinquième et sixième rapports SNIR5, SNIR6, puis adapte la modulation actuelle de la première liaison descendante (224) en fonction de la valeur la plus grande des cinquième et sixième rapports SNIR5, SNIR6 tout en laissant inchangé le codage actuel.

7. Procédé de transport transparent selon l'une quelconque des revendications 1 à 6, dans lequel
Les étapes de signalisation, consistant à insérer et extraire dans un premier champ et un deuxième champs les informations représentatives des rapports SNIR1, SNIR2, SNIR3, SNIR4, SNIR5, SNIR6 ajoutées aux paquets, sont remplacées par des étapes d'acheminement des mesures des SNIR1, SNIR2, SNIR3, SNIR4, SNIR5, SNIR6 et de réacheminement desdites mesures à la station pertinente parmi la première station et la deuxième station ou au satellite pertinent pris parmi le satellite de départ et le satellite de destination, les étapes d'acheminement et de réacheminement étant mises en oeuvre par une station centrale de coordination du système de télécommunications.

8. Procédé de transport transparent selon l'une quelconque des revendications 1 à 7, dans lequel le ou les paquets de données du premier paquet et/ou du deuxième paquet de données ont la structure d'une trame de bande de base BBFRAME codée ou non codée telle que définie par le protocole DVB-S2.

9. Procédé de transport transparent selon la revendication 8, dans lequel les paquets de données commutés à bord des satellites sont des paquets de données ayant la structure d'une trame de bande de base BBFRAME codée selon le protocole DVB-S2 et conservant la structure du codage de bout en bout.

10. Système de télécommunications par satellites pour transporter de manière transparente des données à débit élevé de bout en bout et comprenant
Une première station (4 ; 204) de départ; et
Une deuxième station (6 ; 206) de destination ; et
Un premier satellite (8 ; 218) de départ, connecté directement à la première station (4 ; 204) par une première liaison électromagnétique montante (22 ; 222) depuis la première station (4 ; 204) et par une première liaison électromagnétique descendante (24 ; 224) depuis le premier satellite ; et
Un deuxième satellite (10 ; 220) de destination, connecté directement à la deuxième station (6 ; 206) par une deuxième liaison électromagnétique montante (32 ; 232) depuis la deuxième station (6 ; 206) et par une deuxième liaison électromagnétique descendante (34 ; 234) depuis le deuxième satellite (10 ; 220) ;
Le premier satellite (8 ; 218) de départ et le deuxième satellite de destination (10 ; 220) étant interconnectés par un réseau spatial (42 ; 242) comportant au moins une liaison inter-satellite (44 ; 244);
.- la première station (4 ; 204) de départ étant configurée dans une première étape pour émettre un premier message de données, destiné à la deuxième station (6 : 206) de destination et fragmenté en un unique ou plusieurs premiers paquets (52 , 92 ; 302) de données, chaque premier paquet (52, 92 ; 302) ayant une structure générique ou trame définie par une norme prédéterminée,
Le système de télécommunications étant **caractérisé en ce que**
le premier satellite (8 ; 218) de départ est configuré pour estimer dans une deuxième étape un premier rapport du niveau signal à bruit et interférence SNIR1 de la première liaison montante (22 ; 222) à partir d'un premier paquet actuel (52) reçu et insère une information (62), représentative du premier rapport SNIR1 dans un premier champ aller (64) de données, ajouté au paquet (52), et retransmet de manière transparente ledit paquet (52) et l'information (62) contenue dans le premier champ aller (64) au deuxième satellite (10 ; 220); et
le deuxième satellite (10 ; 220) de destination est configuré pour retransmettre dans une troisième étape ledit premier paquet (52) et l'information contenue dans le premier champ (64) à la deuxième station (6 ; 206) de destination ; et
la deuxième station (6 ; 206) est configurée pour estimer dans une quatrième étape un deuxième rapport du niveau signal à bruit et interférence SNIR2 de la deuxième liaison descendante (34 ; 234) à partir dudit premier paquet (52) retransmis par le deuxième satellite (10 ; 220), puis déterminer un troisième rapport du niveau signal à bruit et interférence SNIR3 d'une première liaison complète (70 ; 208) depuis la première station (4 ; 204) jusqu'à la deuxième station (6 ; 206) comme étant le minimum de l'ensemble formé par les premier et deuxième rapports SNIR1 et SNIR2, puis insère une information (72), représentative du troisième rapport SNIR3 dans un premier champ retour (74) de données, ajouté au ou déjà inclus dans un deuxième paquet (82 ; 282) d'un deuxième message destiné à la première station (4 ; 204), et transmettre ledit deuxième paquet (82 ; 282) et l'information (72) contenue dans le premier champ retour (74) à la première station (4 ; 204) via le deuxième satellite (10 ; 220), le réseau spatial (42 ; 242) et le premier satellite (8 ; 218); et
la première station (4 ; 204) est configurée pour déterminer dans une cinquième étape un premier couple de paramètres de modulation et codage adapté en fonction du troisième rapport SNIR3 envoyé par la deuxième station (6 ; 206) et émettre les paquets (92 ; 302) du premier message ou d'autres messages destinés à la deuxième station (6 ; 206) suivant le premier couple de paramètres.

11. Système de télécommunications par satellites selon la revendication 10, dans lequel
le deuxième satellite (220) de destination est configuré pour estimer dans une septième étape, consécutive à la quatrième étape, un quatrième rapport du niveau signal à bruit et interférence SNIR4 de la deuxième liaison montante (232) à partir d'un deuxième paquet actuel (282) reçu et insère une information (292) représentative du quatrième rapport SNIR4 dans un deuxième champ aller (294) de données, ajouté au deuxième paquet (282), et retransmettre de manière transparente ledit deuxième paquet (282) et l'information (292) contenu dans le deuxième champ aller (294) au premier satellite (218); et
le premier satellite (218) est configuré pour retransmettre dans une huitième étape ledit deuxième paquet (282) et l'information (292) contenue dans le deuxième champ aller (294) à la première station (204); et
la première station (204) est configurée pour estimer dans une neuvième étape un cinquième rapport du niveau signal à bruit et interférence SNIR5 de la première liaison descendante (224) à partir dudit deuxième paquet (282) retransmis par le premier satellite (218), puis déterminer un sixième rapport du niveau signal à bruit et interférence SNIR6 d'une deuxième liaison complète (210) depuis la deuxième station (206) jusqu'à la première station (204) comme étant le minimum de l'ensemble formé par les quatrième et cinquième rapports SNIR4 et SNIR5, puis insérer une information (312), représentative du sixième rapport SNIR6, dans un deuxième champ retour (314) de données, ajouté dans un premier paquet (302) du premier message ou d'un autre message destiné à la deuxième station (206), et transmettre ledit premier paquet (302) et l'information (312) contenue dans le deuxième champ retour (314) à la deuxième station (206) via le premier satellite (218), le réseau spatial (242) et le deuxième satellite (220) ; et
la deuxième station (206) est configurée pour déterminer dans une dixième étape un deuxième couple de paramètres de modulation et codage adapté en fonction du sixième rapport SNIR6 envoyé par la première station (204) et émettre les paquets du deuxième message ou d'autres messages destinés à la première station (204).

12. Système de télécommunications selon l'une quelconque des revendications 10 à 11,
comprenant en outre une station centrale de coordination du système de télécommunications ; et
dans lequel les étapes de signalisation consistant à insérer et extraire dans un premier champ et un deuxième champs les informations représentatives des rapports SNIR1, SNIR2, SNIR3, SNIR4, SNIR5, SNIR6 ajoutées aux paquets sont remplacées par des étapes d'acheminement des mesures des SNIR1, SNIR2, SNIR3, SNIR4, SNIR5, SNIR6 et de réacheminement desdites mesures à la station pertinente parmi la première station et la deuxième station ou au satellite pertinent pris parmi le satellite de départ et le satellite de destination,
la station centrale de coordination du système de télécommunications étant configurée pour mettre en oeuvre lesdites étapes d'acheminement et de réacheminement de signalisation.

13. Produit ou programme d'ordinateur comprenant un ensemble d'instructions configurées pour mettre en oeuvre le procédé de transport transparent défini selon l'une quelconque des revendications 1 à 9 lorsqu'elles sont chargées dans et exécutées par un calculateur un ou plusieurs calculateurs implémentés dans le système de télécommunications défini selon l'une quelconque des revendications 10 à 12.

## Patentansprüche

1. Verfahren zur transparenten Ende-zu-Ende-Datenpaketübertragung, implementiert durch ein Satellitentelekommunikationssystem (2; 202),
wobei das Telekommunikationssystem (2; 202) Folgendes umfasst:
- eine erste Ausgangsstation (4; 204); und
- eine zweite Zielstation (6; 206); und
- einen ersten Ausgangssatelliten (8; 218), der direkt mit der ersten Station (4; 204) durch eine erste elektromagnetische Uplink-Verbindung (22; 222) von der ersten Station (4; 204) und durch eine erste elektromagnetische Downlink-Verbindung (24; 224) vom ersten Satelliten verbunden ist; und
- einen zweiten Zielsatelliten (10; 220), der direkt mit der zweiten Station (6; 206) durch eine zweite elektromagnetische Uplink-Verbindung (32; 232) von der zweiten Station (6; 206) und durch eine zweite elektromagnetische Downlink-Verbindung (34; 234) vom zweiten Satelliten (10; 220) verbunden ist;
wobei der erste Ausgangssatellit (8; 218) und der zweite Zielsatellit (10; 220) durch ein räumliches Netzwerk (42; 242) miteinander verbunden sind, das wenigstens eine Intersatellitenverbindung (44; 244) umfasst;
wobei das transparente Übertragungsverfahren einen ersten Schritt (104) beinhaltet, der Folgendes umfasst:
- die erste Ausgangsstation (4; 204) sendet eine erste Datennachricht, die für die zweite Zielstation (6; 206) bestimmt und in ein oder mehrere erste Datenpakete (52, 92; 302) fragmentiert ist, wobei jedes erste Paket (52, 92; 302) eine(n) von einem vorbestimmten Standard definierte(n) generische(n) Struktur oder Frame hat,
wobei das transparente Übertragungsverfahren ferner die folgenden Schritte beinhaltet:
- in einem zweiten Schritt (106) Schätzen, durch den ersten Ausgangssatelliten (8; 218), eines ersten Signal-Rausch-plus-Interferenz-Verhältnisses SNIR1 der ersten Uplink-Verbindung (22; 222) auf der Basis eines ersten empfangenen aktuellen Pakets (52), und Einführen einer Information (62), die das erste Verhältnis SNIR1 in einem ersten Gehezu-Daten-Feld (64) repräsentiert, hinzugefügt zu dem Paket (52), und transparentes Neusenden des Pakets (52) und der in dem ersten Gehezu-Daten-Feld (64) enthaltenen Information (62) zu dem zweiten Satelliten (10; 220); dann
- in einem dritten Schritt (108) Neusenden, durch den zweiten Satelliten (10; 220), des ersten Pakets (52) und der im ersten Feld (64) enthaltenen Information (62) zur zweiten Zielstation (6; 206); dann
- in einem vierten Schritt (110) Schätzen, durch die zweite Station (6; 206), eines zweiten Signal-Rausch-plus-Interferenz-Verhältnisses SNIR2 der zweiten Downlink-Verbindung (34; 234) auf der Basis des vom zweiten Satelliten (10; 220) neu gesendeten ersten Pakets (52), dann Bestimmen eines dritten Signal-Rausch-plus-Interferenz-Verhältnisses SNIR3 einer ersten kompletten Verbindung (70; 208) von der ersten Station (4; 204) zur zweiten Station (6; 206) als das Minimum des durch das erste und zweite Verhältnisses SNIR1 und SNIR2 gebildeten Satzes, dann Einführen einer das dritte Verhältnis repräsentierenden Information (72) in ein erstes Datenrückkehrfeld (74), hinzugefügt zu oder bereits enthalten in einem zweiten Paket (82; 282) einer für die erste Station (4; 204) bestimmten zweiten Nachricht, und Senden des zweiten Pakets (82; 282) und der im ersten Rückkehrfeld (74) enthaltenen Information (72) zur ersten Station (4; 204) über den zweiten Satelliten (10; 220), das räumliche Netzwerk (42; 242) und den ersten Satelliten (8, 218); dann
- in einem fünften Schritt (112) Bestimmen, durch die erste Station (4; 204), eines ersten Paares von Modulations- und Codierparametern, ausgelegt in Abhängigkeit von dem durch die zweite Station (6; 206) gesendeten dritten Verhältnis SNIR3, und Senden der Pakete (92; 302) der ersten Nachricht oder anderer für die zweite Station (6; 206) bestimmter Nachrichten gemäß dem ersten Parameterpaar.

2. Transparentes Übertragungsverfahren nach Anspruch 1, wobei die Schätzungen des ersten, zweiten und dritten Signal-Rausch-plus-Interferenz-Verhältnisses SNIR1, SNIR2, SNIR3 periodisch gemäß einer als Zeit oder als Anzahl von Paketen ausgedrückten vorbestimmten Periode implementiert werden.

3. Transparentes Übertragungsverfahren nach einem der Ansprüche 1 und 2, wobei im vierten Schritt die zweite Station auch eine Information in das erste Datenrückkehrfeld einführt, die das zweite Verhältnis SNIR2 repräsentiert;
wobei das Übertragungsverfahren ferner einen sechsten Schritt (124) zwischen dem vierten Schritt (110) und dem fünften Schritt (112) beinhaltet, in dem der zweite Satellit (10; 220) das zweite und dritte Verhältnis SNIR2, SNIR3 empfängt und extrahiert, dann die aktuelle Modulation der zweiten Downlink-Verbindung (34) in Abhängigkeit vom größten Wert des zweiten und dritten Verhältnisses SNIR2, SNIR3 adaptiert und dabei die aktuelle Codierung unverändert lässt.

4. Transparentes Übertragungsverfahren nach einem der Ansprüche 1 bis 3, das ferner die Schritte beinhaltet, die Folgendes umfassen:
- in einem siebten Schritt (354), der auf den vierten Schritt (110) folgt, erfolgendes Schätzen, durch den zweiten Zielsatelliten (220), eines vierten Signal-Rausch-plus-Interferenz-Verhältnisses SNIR4 der zweiten Uplink-Verbindung (232) auf der Basis eines zweiten empfangenen aktuellen Pakets (282) und Einführen einer Information (292), die das vierte Verhältnis SNIR4 repräsentiert, in ein zweites Gehezu-Daten-Feld (294), hinzugefügt zum zweiten Paket (282), und transparentes Neusenden des zweiten Pakets (282) und der im zweiten Gehezu-Feld (294) enthaltenen Informationen (292) zum ersten Satelliten (218); dann
- in einem achten Schritt (356) erfolgendes Neusenden, durch den ersten Satelliten, des zweiten Pakets (282) und der im zweiten Gehezu-Feld (294) enthaltenen Information (292) zur ersten Station (204); dann
- in einem neunten Schritt (358) erfolgendes Schätzen, durch die erste Station (204), eines fünften Signal-Rausch-plus-Interferenz-Verhältnisses SNIR5 der ersten Downlink-Verbindung (224) auf der Basis des vom ersten Satelliten (218) neu gesendeten zweiten Pakets (282), dann Bestimmen eines sechsten Signal-Rausch-plus-Interferenz-Verhältnisses SNIR6 einer zweiten kompletten Verbindung (210) von der zweiten Station (206) zur ersten Station (204) als das Minimum des aus dem vierten und fünften Verhältnis SNIR4 und SNIR5 gebildeten Satzes, dann Einführen einer Information (312), die das sechste Verhältnis SNIR6 repräsentiert, in ein zweites Datenrückkehrfeld (314), hinzugefügt zu einem ersten Paket (302) der ersten Nachricht oder einer anderen für die zweite Station (206) bestimmten Nachricht, und Senden des ersten Pakets (302) und der im zweiten Rückkehrfeld (314) enthaltenen Information (312) zur zweiten Station (206) über den ersten Satelliten (218), das räumliche Netzwerk (242) und den zweiten Satelliten (220); dann
- in einem zehnten Schritt (360) erfolgendes Bestimmen, durch die zweite Station (206), eines zweiten Paares von Modulations- und Codierparametern, ausgelegt in Abhängigkeit von dem von der ersten Station (204) gesendeten sechsten Verhältnis SNIR6, und Senden der Pakete der zweiten Nachricht oder von anderen für die erste Station (204) bestimmten Nachrichten.

5. Transparentes Übertragungsverfahren nach Anspruch 4, wobei die Schätzungen des vierten, fünften und sechsten Signal-Rausch-plus-Interferenz-Verhältnisses SNIR4, SNIR5, SNIR6 periodisch gemäß einer als Zeit oder als Anzahl von Paketen ausgedrückten vorbestimmten Periode implementiert werden.

6. Transparentes Übertragungsverfahren nach einem der Ansprüche 4 und 5, wobei im neunten Schritt die erste Station auch eine Information in das zweite Datenrückkehrfeld einführt, die das fünfte Verhältnis SNIR5 repräsentiert;
wobei das Übertragungsverfahren ferner einen elften Schritt zwischen dem neunten Schritt (358) und dem zehnten Schritt (360) umfasst, in dem der erste Satellit (218) das fünfte und sechste Verhältnis SNIR5, SNIR6 empfängt und extrahiert, dann die aktuelle Modulation der ersten Downlink-Verbindung (224) in Abhängigkeit vom größten Wert des fünften und sechsten Verhältnisses SNIR5, SNIR6 adaptiert und dabei die aktuelle Codierung unverändert lässt.

7. Transparentes Übertragungsverfahren nach einem der Ansprüche 1 bis 6, wobei
die Signalisierungsschritte, bestehend im Einführen und Extrahieren in ein/aus einem erstes/n Feld und zweites/n Feld der Informationen, die die Verhältnisse SNIR1, SNIR2, SNIR3, SNIR4, SNIR5, SNIR6, hinzugefügt zu den Paketen, durch Schritte des Routens der Messwerte von SNIR1, SNIR2, SNIR3, SNIR4, SNIR5, SNIR6 und des Reroutens der Messwerte zu der relevanten Station von der ersten Station und der zweiten Station oder zu dem relevanten Satelliten beinhaltet, ausgewählt aus dem Ausgangssatelliten und dem Zielsatelliten, wobei die Routing- und Rerouting-Schritte durch eine Zentralstation des Koordinierens des Telekommunikationssystems implementiert werden.

8. Transparentes Übertragungsverfahren nach einem der Ansprüche 1 bis 7, in dem die ein oder mehreren Datenpakete des ersten Pakets und/oder des zweiten Datenpakets die Struktur eines codierten oder uncodierten Basisband-Frame BBFRAME wie durch das DVB-S2 Protokoll definiert haben.

9. Transparentes Übertragungsverfahren nach Anspruch 8, in dem die an Bord der Satelliten geschalteten Datenpakete Datenpakete mit der Struktur eines Basisband-Frames BBFRAME haben, codiert gemäß dem DVB-S2 Protokoll, und unter Beibehaltung der Ende-zu-Ende-Codierstruktur.

10. Satellitentelekommunikationssystem für die transparente Ende-zu-Ende-Übertragung von Daten mit hoher Bitrate, das Folgendes umfasst:
- eine erste Ausgangsstation (4; 204); und
- eine zweite Zielstation (6; 206); und
- einen ersten Ausgangssatelliten (8; 218), der direkt mit der ersten Station (4; 204) durch eine erste elektromagnetische Uplink-Verbindung (22; 222) von der ersten Station (4; 204) und durch eine elektromagnetische Downlink-Verbindung (24; 224) vom ersten Satelliten verbunden ist; und
- einen zweiten Zielsatelliten (10; 220), der direkt mit der zweiten Station (6; 206) über eine zweite elektromagnetische Uplink-Verbindung (32; 232) von der zweiten Station (6; 206) und durch eine zweite elektromagnetische Downlink-Verbindung (34; 234) vom zweiten Satelliten (10; 220) verbunden ist;
wobei der erste Ausgangssatellit (8; 218) und der zweite Zielsatellit (10; 220) durch ein räumliches Netzwerk (42; 242) miteinander verbunden sind, das wenigstens eine Intersatellitenverbindung (44; 244) umfasst;
- wobei die erste Ausgangsstation (4; 204) in einem ersten Schritt zum Senden einer ersten Datennachricht konfiguriert ist, die für den zweiten Zielsatelliten (6; 206) bestimmt und in eines oder mehrere Datenpakete (52, 92; 302) fragmentiert ist, wobei jedes erste Paket (52, 92; 302) eine(n) durch einen vorbestimmten Standard definierte(n) generische(n) Struktur oder Frame hat,
wobei das Telekommunikationssystem **dadurch gekennzeichnet ist, dass**:
- der erste Ausgangssatellit (8; 218) konfiguriert ist zum in einem zweiten Schritt erfolgenden Schätzen eines ersten Signal-Rausch-plus-Interferenz-Verhältnisses SNIR1 der ersten Uplink-Verbindung (22; 222) auf der Basis eines ersten empfangenen aktuellen Pakets (52) und zum Einführen einer das erste Verhältnis SNIR1 repräsentierenden Information (62) in ein erstes Gehezu-Daten-Feld (64), hinzugefügt zu dem Paket (52), und zum transparenten Neusenden des Pakets (52) und der im ersten Gehezu-Daten-Feld (64) enthaltenen Information (62) zum zweiten Satelliten (10; 220); und
- der zweite Zielsatellit (10; 220) konfiguriert ist zum in einem dritten Schritt erfolgenden Neusenden des ersten Pakets (52) und der im ersten Feld (64) enthaltenen Information zur zweiten Zielstation (6; 206); und
- die zweite Station (6; 206) konfiguriert ist zum in einem vierten Schritt erfolgenden Schätzen eines zweiten Signal-Rausch-plus-Interferenz-Verhältnisses SNIR2 der zweiten Downlink-Verbindung (34; 234) auf der Basis des vom zweiten Satelliten (10; 220) neu gesendeten ersten Pakets (52), dann zum Bestimmen eines dritten Signal-Rausch-plus-Interferenz-Verhältnisses SNIR3 einer ersten kompletten Verbindung (70; 208) von der ersten Station (4; 204) zur zweiten Station (6; 206) als das Minimum des aus dem ersten und zweiten Verhältnis SNIR1 und SNIR2 gebildeten Satzes, dann zum Einführen einer das dritte Verhältnis SNIR3 repräsentierenden Information (72) in ein erstes Datenrückkehrfeld (74), hinzugefügt zu oder bereits enthalten in einem zweiten Paket (82; 282) einer zweiten Nachricht, die für die erste Station (4; 204) bestimmt ist, und zum Senden des zweiten Pakets (82; 282) und der im ersten Rückkehrfeld (74) enthaltenen Information (72) zur ersten Station (4; 204) über den zweiten Satelliten (10; 220), das räumliche Netzwerk (42; 242) und den ersten Satelliten (8, 218); und
- die erste Station (4; 204) konfiguriert ist zum in einem fünften Schritt erfolgenden Bestimmen eines ersten Paares von Modulations- und Codierparametern, ausgelegt in Abhängigkeit von dem von der zweiten Station (6; 206) gesendeten dritten SNIR3 und zum Senden der Pakete (92; 302) der ersten Nachricht oder von anderen für die zweite Station (6; 206) bestimmten Nachrichten gemäß dem ersten Parameterpaar.

11. Satellitentelekommunikationssystem nach Anspruch 10, bei dem
der zweite Empfangs Satellit (220) konfiguriert ist zum in einem siebten Schritt nach dem vierten Schritt erfolgenden Schätzen eines vierten Signal-Rausch-plus-Interferenz-Verhältnisses SNIR4 der zweiten Uplink-Verbindung (232) auf der Basis eines zweiten empfangenen aktuellen Pakets (282) und zum Einführen einer das vierte Verhältnis SNIR4 repräsentierenden Information (292) in ein zweites Gehezu-Daten-Feld (294), hinzugefügt zum zweiten Paket (282), und zum transparenten Neusenden des zweiten Pakets (282) und der zweiten im Gehezu-Feld (294) enthaltenen Information (292) zum ersten Satelliten (218); und
- der erste Satellit (218) konfiguriert ist zum in einem achten Schritt erfolgenden Neusenden des zweiten Pakets (282) und der im zweiten Gehezu-Feld (294) enthaltenen Information (292) zur ersten Station (204); und
- die erste Station (204) konfiguriert ist zum in einem neunten Schritt erfolgenden Schätzen eines fünften Signal-Rausch-plus-Interferenz-Verhältnisses SNIR5 der ersten Downlink-Verbindung (224) auf der Basis des vom ersten Satelliten (218) neu gesendeten zweiten Pakets (282), dann zum Bestimmen eines sechsten Signal-Rausch-plus-Interferenz-Verhältnisses SNIR6 einer zweiten kompletten Verbindung (210) von der zweiten Station (206) zur ersten Station (204) als das Minimum des durch das vierte und fünfte Verhältnis SNIR4 und SNIR5 gebildeten Satzes, dann zum Einführen einer das sechste Verhältnis SNIR6 repräsentierenden Information (312) in ein zweites Datenrückkehrfeld (314), hinzugefügt zu einem ersten Paket (302) der ersten Nachricht oder einer anderen für die zweite Station (206) bestimmten Nachricht, und zum Senden des ersten Pakets (302) und der im zweiten Rückkehrfeld (314) enthaltenen Information (312) zur zweiten Station (206) über den ersten Satelliten (218), das räumliche Netzwerk (242) und den zweiten Satelliten (220); und
- die zweite Station (206) konfiguriert ist zum in einem zehnten Schritt erfolgenden Bestimmen eines zweiten Paares von Modulations- und Codierparametern, ausgelegt in Abhängigkeit von dem von der ersten Station (204) gesendeten sechsten Verhältnis SNIR6 und zum Senden der Pakete der zweiten Nachricht oder von anderen für die erste Station (204) bestimmten Nachrichten.

12. Telekommunikationssystem nach einem der Ansprüche 10 bis 11,
das ferner eine Zentralstation zum Koordinieren des Telekommunikationssystems umfasst und
in dem die Signalisierungsschritte bestehend im Einführen und Extrahieren, in ein/aus einem erstes/n Feld und zweites/n Feld, der Informationen, die die Verhältnisse SNIR1, SNIR2, SNIR3, SNIR4, SNIR5, SNIR6 repräsentieren, hinzugefügt zu den Paketen, durch Schritte des Routens der Messwerte von SNIR1, SNIR2, SNIR3, SNIR4, SNIR5, SNIR6 und des Reroutens der Messwerte zu der relevanten Station von der ersten Station und der zweiten Station oder zum relevanten Satelliten ersetzt werden, ausgewählt aus dem Ausgangssatelliten und dem Zielsatelliten,
wobei die Zentralstation zum Koordinieren des Telekommunikationssystems zum Implementieren der Schritte des Routens und Reroutens der Signalisierung konfiguriert ist.

13. Produkt oder Computerprogramm, umfassend einen Satz von Befehlen, konfiguriert zum Implementieren des transparenten Übertragungsverfahrens wie in einem der Ansprüche 1 bis 9 definiert, wenn sie in einen oder mehrere Computer, implementiert in dem Telekommunikationssystem gemäß Definition nach einem der Ansprüche 10 bis 12, geladen oder davon abgearbeitet werden.

## Claims

1. A method for transparent end-to-end data packet transmission implemented by a satellite telecommunications system (2; 202),
the telecommunications system (2; 202) comprising:
- a first source station (4; 204); and
- a second destination station (6; 206); and
- a first source satellite (8; 218) directly connected to the first station (4; 204) by a first electromagnetic uplink (22; 222) from the first station (4; 204) and by a first electromagnetic downlink (24; 224) from the first satellite; and
- a second destination satellite (10; 220) directly connected to the second station (6; 206) by a second electromagnetic uplink (32; 232) from the second station (6; 206) and by a second electromagnetic downlink (34; 234) from the second satellite (10; 220);
the first source satellite (8; 218) and the second destination satellite (10; 220) being interconnected by a space network (42; 242) comprising at least one inter-satellite link (44; 244);
the transparent transmission method comprising a first step (104) comprising:
- the first source station (4; 204) transmitting a first data message intended for the second destination station (6; 206) and fragmented into one or a plurality of first data packets (52, 92; 302), each first packet (52, 92; 302) having a generic structure or frame defined by a predetermined standard,
the transparent transmission method further comprising the following steps:
- in a second step (106), the first source satellite (8; 218) estimating a first signal-to-noise-plus-interference ratio SNIR1 of the first uplink (22; 222) on the basis of a first received current packet (52) and introducing information (62) representing the first ratio SNIR1 into a first data go-to field (64), added to the packet (52), and transparently retransmitting said packet (52) and the information (62) contained in the first data go-to field (64) to the second satellite (10; 220); then
- in a third step (108), the second satellite (10; 220) retransmitting said first packet (52) and the information (62) contained in the first field (64) to the second destination station (6; 206); then
- in a fourth step (110), the second station (6; 206) estimating a second signal-to-noise-plus-interference ratio SNIR2 of the second downlink (34; 234) on the basis of said first packet (52) retransmitted by the second satellite (10; 220), then determining a third signal-to-noise-plus-interference ratio SNIR3 of a first complete link (70; 208) from the first station (4; 204) to the second station (6; 206) as being the minimum from the set formed by the first and second ratios SNIR1 and SNIR2, then introducing information (72) representing the third ratio into a first data return field (74), added to or already included within a second packet (82; 282) of a second message intended for the first station (4; 204), and transmitting said second packet (82; 282) and the information (72) contained in the first return field (74) to the first station (4; 204) via the second satellite (10; 220), the space network (42; 242) and the first satellite (8, 218); then
- in a fifth step (112), the first station (4; 204) determining a first pair of modulation and coding parameters adapted as a function of the third ratio SNIR3 sent by the second station (6; 206) and transmitting the packets (92; 302) of the first message or of other messages intended for the second station (6; 206) according to the first pair of parameters.

2. The transparent transmission method according to claim 1, the estimates of the first, second and third signal-to-noise-plus-interference ratios SNIR1, SNIR2, SNIR3 being periodically implemented according to a predetermined period expressed as time or as a number of packets.

3. The transparent transmission method according to any one of claims 1 and 2, wherein, during the fourth step, the second station also introduces information into the first data return field that represents the second ratio SNIR2;
the transmission method further comprising a sixth step (124), placed between the fourth step (110) and the fifth step (112), in which the second satellite (10; 220) receives and extracts the second and third ratios SNIR2, SNIR3, then adapts the current modulation of the second downlink (34) as a function of the largest value of the second and third ratios SNIR2, SNIR3, whilst leaving the current coding unchanged.

4. The transparent transmission method according to any one of claims 1 to 3, further comprising the steps consisting in the following:
- in a seventh step (354), following the fourth step (110), the second destination satellite (220) estimates a fourth signal-to-noise-plus-interference ratio SNIR4 of the second uplink (232) on the basis of a second received current packet (282) and introduces information (292) representing the fourth ratio SNIR4 into a second data go-to field (294), added to the second packet (282), and transparently retransmits said second packet (282) and the information (292) contained in the second go-to field (294) to the first satellite (218); then
- in an eighth step (356), the first satellite retransmits said second packet (282) and the information (292) contained in the second go-to field (294) to the first station (204); then
- in a ninth step (358), the first station (204) estimates a fifth signal-to-noise-plus-interference SNIR5 of the first downlink (224) on the basis of said second packet (282) retransmitted by the first satellite (218), then determines a sixth signal-to-noise-plus-interference ratio SNIR6 of a second complete link (210) from the second station (206) to the first station (204) as being the minimum from the set formed by the fourth and fifth ratios SNIR4 and SNIR5, then introduces information (312) representing the sixth ratio SNIR6 into a second data return field (314), added to a first packet (302) of the first message or of another message intended for the second station (206), and transmits said first packet (302) and the information (312) contained in the second return field (314) to the second station (206) via the first satellite (218), the space network (242) and the second satellite (220); then
- in a tenth step (360), the second station (206) determines a second pair of modulation and coding parameters adapted as a function of the sixth ratio SNIR6 sent by the first station (204) and transmits the packets of the second message or of other messages intended for the first station (204).

5. The transparent transmission method according to claim 4, the estimates of the fourth, fifth and sixth signal-to-noise-plus-interference ratios SNIR4, SNIR5, SNIR6 being periodically implemented according to a predetermined period expressed as time or as a number of packets.

6. The transparent transmission method according to any one of claims 4 and 5, wherein, during the ninth step, the first station also introduces information into the second data return field that represents the fifth ratio SNIR5;
the transmission method further comprising an eleventh step, placed between the ninth step (358) and the tenth step (360), in which the first satellite (218) receives and extracts the fifth and sixth ratios SNIR5, SNIR6, then adapts the current modulation of the first downlink (224) as a function of the largest value of the fifth and sixth ratios SNIR5, SNIR6, whilst leaving the current coding unchanged.

7. The transparent transmission method according to any one of claims 1 to 6, wherein
the signalling steps involving introducing and extracting, into/from a first field and a second field, information representing the ratios SNIR1, SNIR2, SNIR3, SNIR4, SNIR5, SNIR6 added to the packets are replaced by steps of routing the measurements of SNIR1, SNIR2, SNIR3, SNIR4, SNIR5, SNIR6 and of rerouting said measurements to the relevant station from the first station and the second station or to the relevant satellite selected from the source satellite and the destination satellite, the routing and rerouting steps being implemented by a central station for coordinating the telecommunications system.

8. The transparent transmission method according to any one of claims 1 to 7, wherein the one or more data packets of the first packet and/or of the second data packet have the structure of a coded or uncoded baseband frame BBFRAME such as that defined by the DVB-S2 protocol.

9. The transparent transmission method according to claim 8, wherein the data packets switched on board satellites are data packets having the structure of a baseband frame BBFRAME coded according to the DVB-S2 protocol and maintaining the end-to-end coding structure.

10. A satellite telecommunications system for transparent end-to-end transmission of high bit-rate data and comprising:
- a first source station (4; 204); and
- a second destination station (6; 206); and
- a first source satellite (8; 218) directly connected to the first station (4; 204) by a first electromagnetic uplink (22; 222) from the first station (4; 204) and by a first electromagnetic downlink (24; 224) from the first satellite; and
- a second destination satellite (10; 220) directly connected to the second station (6; 206) by a second electromagnetic uplink (32; 232) from the second station (6; 206) and by a second electromagnetic downlink (34; 234) from the second satellite (10; 220);
the first source satellite (8; 218) and the second destination satellite (10; 220) being interconnected by a space network (42; 242) comprising at least one inter-satellite link (44; 244);
- the first source station (4; 204) being configured in a first step to transmit a first data message intended for the second destination station (6; 206) and fragmented into one or a plurality of data packets (52, 92; 302), each first packet (52, 92; 302) having a generic structure or frame defined by a predetermined standard,
the telecommunications system being **characterised in that**:
- in a second step, the first source satellite (8; 218) is configured to estimate a first signal-to-noise-plus-interference ratio SNIR1 of the first uplink (22; 222) on the basis of a first received current packet (52) and to introduce information (62) representing the first ratio SNIR1 into a first data go-to field (64), added to the packet (52), and to transparently retransmit said packet (52) and the information (62) contained in the first data go-to field (64) to the second satellite (10; 220); and
- in a third step, the second satellite (10; 220) is configured to retransmit said first packet (52) and the information contained in the first field (64) to the second destination station (6; 206); and
- in a fourth step, the second station (6; 206) is configured to estimate a second signal-to-noise-plus-interference ratio SNIR2 of the second downlink (34; 234) on the basis of said first packet (52) retransmitted by the second satellite (10; 220), then to determine a third signal-to-noise-plus-interference ratio SNIR3 of a first complete link (70; 208) from the first station (4; 204) to the second station (6; 206) as being the minimum from the set formed by the first and second ratios SNIR1 and SNIR2, then to introduce information (72) representing the third ratio SNIR3 into a first data return field (74), added to or already included within a second packet (82; 282) of a second message intended for the first station (4; 204), and to transmit said second packet (82; 282) and the information (72) contained in the first return field (74) to the first station (4; 204) via the second satellite (10; 220), the space network (42; 242) and the first satellite (8, 218); and
- in a fifth step, the first station (4; 204) is configured to determine a first pair of modulation and coding parameters adapted as a function of the third ratio SNIR3 sent by the second station (6; 206) and to transmit the packets (92; 302) of the first message or of other messages intended for the second station (6; 206) according to the first pair of parameters.

11. The satellite telecommunications system according to claim 10, wherein,
in a seventh step following the fourth step, the second destination satellite (220) is configured to estimate a fourth signal-to-noise-plus-interference ratio SNIR4 of the second uplink (232) on the basis of a second received current packet (282) and to introduce information (292) representing the fourth ratio SNIR4 into a second data go-to field (294), added to the second packet (282), and to transparently retransmit said second packet (282) and the information (292) contained in the second go-to field (294) to the first satellite (218); and
- in an eighth step, the first satellite (218) is configured to retransmit said second packet (282) and the information (292) contained in the second go-to field (294) to the first station (204); and
- in a ninth step, the first station (204) is configured to estimate a fifth signal-to-noise-plus-interference SNIR5 of the first downlink (224) on the basis of said second packet (282) retransmitted by the first satellite (218), then to determine a sixth signal-to-noise-plus-interference ratio SNIR6 of a second complete link (210) from the second station (206) to the first station (204) as being the minimum from the set formed by the fourth and fifth ratios SNIR4 and SNIR5, then to introduce information (312) representing the sixth ratio SNIR6 into a second data return field (314), added to a first packet (302) of the first message or of another message intended for the second station (206), and to transmit said first packet (302) and the information (312) contained in the second return field (314) to the second station (206) via the first satellite (218), the space network (242) and the second satellite (220); and
- in a tenth step, the second station (206) is configured to determine a second pair of modulation and coding parameters adapted as a function of the sixth ratio SNIR6 sent by the first station (204) and to transmit the packets of the second message or of other messages intended for the first station (204).

12. The telecommunications system according to any one of claims 10 to 11,
further comprising a central station for coordinating the telecommunications system and
wherein the signalling steps involving introducing and extracting, into/from a first field and a second field, information representing the ratios SNIR1, SNIR2, SNIR3, SNIR4, SNIR5, SNIR6 added to the packets are replaced by steps of routing the measurements of SNIR1, SNIR2, SNIR3, SNIR4, SNIR5, SNIR6 and of rerouting said measurements to the relevant station from the first station and the second station or to the relevant satellite selected from the source satellite and the destination satellite,
the central station for coordinating the telecommunications system being configured to implement said steps of routing and rerouting signalling.

13. A product or computer programme comprising a set of instructions configured to implement the transparent transmission method defined as claimed in any one of claims 1 to 9 when they are loaded into and executed by one or more computers implemented in the telecommunications system defined according to any one of claims 10 to 12.
